# EUROPÄISCHE PATENTANMELDUNG

(11) **EP 0 585 656 A2**
(43) Veröffentlichungstag der Anmeldung: **09.03.1994**
(21) Anmeldenummer: 93112686.6
(22) Anmeldetag: 07.08.1993
(51) Int. Cl.: G01R 1/22

(54) **Strommesszange**

(30) Priorität: 01.09.1992 DE 4229065
(71) Anmelder: ROBERT BOSCH GMBH, 70442 Stuttgart (DE)
(72) Erfinder: Bumen, Werner, D-7312 Kirchheim-Oetlingen (DE)

(57) **Zusammenfassung**

Es wird eine Strommeßzange mit zwei zueinander beweglich angeordneten Zangenbacken (10, 11) vorgeschlagen, bei der in einem an einer ersten Trennstelle (12) auftretenden ersten Luftspalt (13) ein magnetfeldempfindlicher Sensor (14) angeordnet ist und bei der an einer zweiten Trennstelle (20) ein zweiter Luftspalt (21) vorgesehen ist, dessen Länge mit einer Spaltfüllung (22) auf ein vorgegebenes Meß festgelegt ist. Die zusätzliche Scherung durch die Einbringung des zweiten Luftspalts (21) erweitert den Bereich, innerhalb dem der Zusammenhang zwischen dem zu messenden Strom (24) und dem Ausgangssignal des magnetfeldempfindlichen Sensors (14) linear ist.

## Beschreibung

### Stand der Technik

Die Erfindung geht aus von einer Strommeßzange nach der Gattung des Hauptanspruchs. Aus der FR-A 2 298 110 ist eine Strommeßzange mit zwei zueinander beweglich angeordneten, zu einem geschlossenen magnetischen Kreis zusammenführbaren Zangenbacken bekannt. Die Zangenbacken, die um einen elektrischen Leiter gelegt werden, führen das Magnetfeld, das einen stromdurchflossenen Leiter umgibt. Die bekannte Strommeßzange enthält zwei identische magnetfeldempfindliche Sensoren, die jeweils in der Trennstelle zwischen den Zangenbacken angeordnet sind. Der Einsatz von zwei identischen magnetfeldempfindlichen Sensoren anstelle von lediglich einem Sensor ist zum Kompensieren des Einflusses von parasitären Magnetfeldern vorgesehen. Die Länge der beiden Luftspalte an den beiden Trennstellen zwischen den Zangenbacken ist durch die Abmessungen der magnetfeldempfindlichen Sensoren nach unten begrenzt.

Die Einfügung eines Luftspaltes in einen magnetischen Kreis führt zu einer Scherung des Kreises, die beispielsweise in dem Fachbuch von R. Boll, "Weichmagnetische Werkstoffe, Einführung in den Magnetismus", 4. Auflage, 1990, Kapitel 4 beschrieben ist. Die Scherung des magnetischen Kreises reduziert dessen relative Permeabilität. Andererseits kann der Bereich vergrößert werden, in welchen die magnetische Feldstärke proportional zur magnetischen Flußdichte ist.

Der Erfindung liegt die Aufgabe zugrunde die Meßgenauigkeit von Strommeßzangen, die einen magnetfeldempfindlichen Sensor enthalten, im Bereich zu höheren Strömen hin zu erhöhen.

Die Aufgabe wird durch die im Hauptanspruch angegebenen Merkmale gelöst.

### Vorteile der Erfindung

Mit der erfindungsgemäßen Strommeßzange ist eine minimale Abweichung von der Proportionalität zwischen dem tatsächlich fließenden Strom und dem Ausgangssignal des magnetfeldempfindlichen Sensors bis zum höchsten zu messenden Strom justierbar. Ein wesentlicher Vorteil liegt darin, daß auch bei nahezu fertig montierten Strommeßzangen nachträglich eine Erhöhung der Meßgenauigkeit durch die erfindungsgemäße Maßnahme vornehmbar ist. Neben der Meßgenauigkeit wird auch die Kernauslastung erhöht, weil die magnetische Flußdichte bis in die Nähe der Sättigung gelangen darf. Der gleiche Meßbereich kann daher bei gleichzeitig kleineren Kernabmessungen erreicht werden.

Vorteilhafte Weiterbildungen der erfindungsgemäßen Strommeßzange ergeben sich aus Unteransprüchen.

Besonders einfach ist die Festlegung der Länge des zweiten Luftspalts mit einer Folie gegebener Stärke. Die Folie kann auf einfachste Weise in die zweite Trennstelle zwischen den beiden Zangenbacken geklebt werden, wo sie den zweiten Luftspalt bildet.

Der Einsatz einer selbstklebenden Folie reduziert die erforderlichen Arbeitsschritte.

Weitere vorteilhafte Weiterbildungen der erfindungsgemäßen Strommeßzange ergeben sich aus weiteren Unteransprüchen in Verbindung mit der folgenden Beschreibung.

### Zeichnung

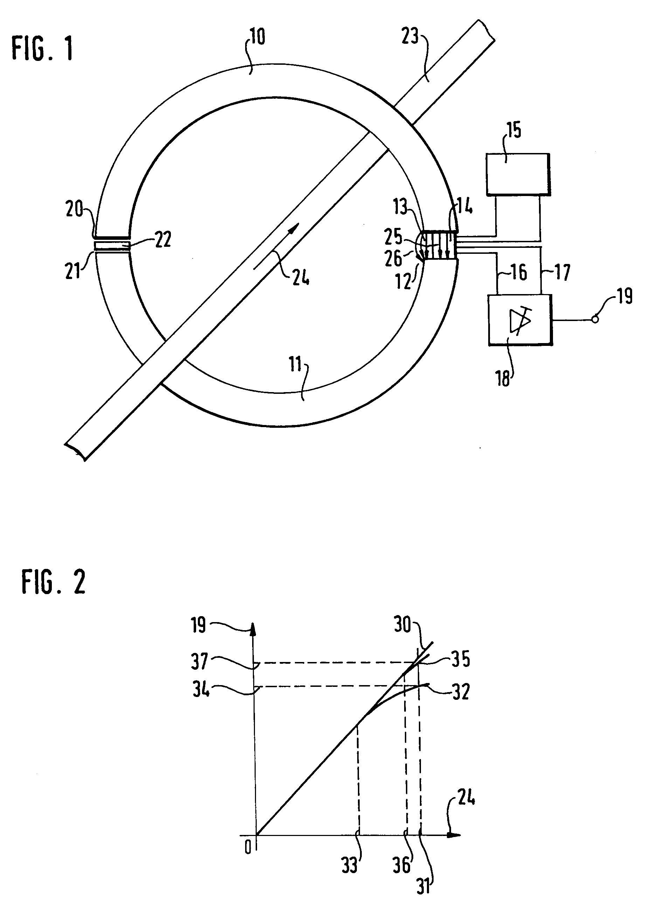

Figur 1 zeigt einen magnetischen Kreis, der einen stromdurchflossenen Leiter umgibt und Figur 2 zeigt einen funktionalen Zusammenhang zwischen dem im Leiter fließenden Strom und einem Ausgangssignal.

Figur 1 zeigt zwei zueinander beweglich angeordnete Zangenbacken 10, 11, die in einer nicht näher gezeigten Strommeßzange angeordnet sind. An einer ersten Trennstelle 12 zwischen den beiden Backen 10, 11 entsteht ein erster Luftspalt 13. Die Länge des ersten Luftspalts 13 ist im wesentlichen durch die Abmessungen eines magnetfeldempfindlichen Sensors 14 festgelegt, der innerhalb des ersten Luftspalts 13 angeordnet ist.

Der Sensor 14 ist mit einer Stromversorgung 15 verbunden. Weiterhin gibt der Sensor 14 über die Leitungen 16, 17 ein Ausgangssignal an eine Verstärkeranordnung 18 ab, die ein aufbereitetes Signal 19 abgibt.

An einer zweiten Trennstelle 20 zwischen den beiden Zangenbacken 10, 11 tritt ein zweiter Luftspalt 21 auf. Die Länge des zweiten Luftspalts 21 ist durch eine Spaltfüllung 22 auf ein vorgegebenes Maß festgelegt.

Die Zangenbacken 10, 11 führen ein Magnetfeld, das einen stromdurchflossenen Leiter 23 umgibt, um den herum die Zangenbacken 10, 11 gelegt sind. Der im Leiter 23 fließende Strom ist mit einem Pfeil 24 eingetragen. Von dem Magnetfeld, das den stromdurchflossenen Leiter 23 umgibt, ist lediglich derjenige Anteil 25 gezeigt, der im ersten Luftspalt 13 auftritt. Das Magnetfeld 25 ist innerhalb der ersten Trennstelle homogen. Im Randbereich der ersten Trennstelle 12 kann ein Streufeld 26 auftreten.

In Figur 2 ist ein funktionaler Zusammenhang zwischen dem tatsächlichen, im Leiter 23 fließenden Strom 24 und dem aufbereiteten Signal 19 gezeigt, das die Verstärkeranordnung 18 abgibt. Eingetragen ist eine Gerade 30, welche einer idealen Kennlinie entspricht, bei der der fließende Strom 24 innerhalb des gesamten Meßbereichs proportional ist zum aufbereiteten Signal 19. Der zulässige Meßbereich liegt zwischen dem Wert Null und einem höchsten, zu messenden Strom 31.

In Figur 2 sind weiterhin eingetragen eine erste Kennlinie 32, die bis zu einer Stromgrenze 33 geradlinig verläuft und anschließend in Richtung höherer Ströme abflacht. Dem höchsten, zu messenden Strom 31 entspricht ein erster Wert 34 des aufbereiteten Signals 19.

Eingetragen ist weiterhin eine zweite Kennlinie 35, die bis zu einer zweiten Stromgrenze 36 geradlinig verläuft und zu höheren Strömen hin leicht abflacht. Dem höchsten, zu messenden Strom 31 wird mit der zweiten Kennlinie 35 ein zweiter Wert 37 des aufbereiteten Signals 19 zugeordnet.

Die in Figur 1 gezeigte Strommeßzange wird anhand des in Figur 2 gezeigten funktionalen Zusammenhangs näher erläutert:

In Figur 1 sind mechanische Teile der Strommeßzange, die zur Erläuterung der Erfindung von untergeordneter Bedeutung sind, nicht eingezeichnet.

Die beiden Zangenbacken 10, 11 sind aus einem magnetisierbaren Material mit einer vorgegebenen relativen Permeabilität hergestellt und bilden einen magnetisierbaren Kern. Die Zangenbacken 10, 11 können beispielsweise, wie in der Figur angedeutet, als Ringkernhälften ausgebildet sein. Die Zangenbacken 10, 11 führen das Magnetfeld, das von dem stromdurchflossenen Leiter 23 ausgeht. Die magnetische Feldstärke ergibt eine magnetische Flußdichte, die im wesentlichen von der relativen Permeabilität des Kernmaterials abhängt. Die magnetische Flußdichte wird von dem im ersten Luftspalt 13 angeordneten magnetfeldempfindlichen Sensor 14 gemessen.

Der Sensor 14 ist beispielsweise als Hall-Element ausgebildet, welches den besonderen Vorteil aufweist, daß es sowohl magnetische Gleich- als auch magnetische Wechselfelder detektieren kann. Zur Vorgabe eines definierten Stroms ist im Falle eines Hall-Elements die Stromversorgung 15 vorgesehen. Der Sensor 14 gibt über die Leitungen 16, 17 ein Ausgangssignal ab, das innerhalb der vom Hersteller angegebenen Grenzen proportional zur magnetischen Flußdichte ist. Dieses Ausgangssignal wird in der Verstärkeranordnung 18 auf ein vorgebbares Maß angehoben und als aufbereitetes Signal 19 abgegeben. Eine variable Verstärkung ermöglicht eine Kalibrierung des aufbereiteten Ausgangssignals 19 bei der Serienherstellung von Strommeßzangen.

Die Länge des ersten Luftspalts 13 ist im wesentlichen durch die Abmessungen des magnetfeldempfindlichen Sensors 14 festgelegt. Zusätzlich zum Sensor 14 können Schutzschichten oder Abstandshalterungen vorgesehen sein, die einer Beschädigung des Sensors 14 vorbeugen. Die nicht frei wählbare Länge des ersten Luftspalts 13 führt zu einer Scherung des magnetischen Kreises, die einer Abnahme der relativen Permeabilität des Zangenbackenmaterials gleichkommt. Gleichzeitig erhöht sich der Bereich, innerhalb dem der Zusammenhang zwischen dem im Leiter 23 fließenden Strom und dem an den Leitungen 16, 17 auftretenden Ausgangssignal des Sensors 14 linear ist.

Unter der Annahme, daß zunächst der zweite Luftspalt 21 nur durch die unvermeidliche zweite Trennstelle 20 zwischen den Zangenbacken 10, 11 gegeben ist, kann der in Figur 1 gezeigten Anordnung die in Figur 2 gezeigte erste Kennlinie 32 zugrundegelegt werden. Der Zusammenhang zwischen dem im Leiter 23 fließenden Strom und dem an den Leitungen 16, 17 liegenden Signal ist bis zur ersten Stromgrenze 33 linear. Da die Verstärkeranordnung 18 als linearer Verstärker angenommen wird, ist diese Linearität auch bezüglich des aufbereiteten Ausgangssignals 19 gegeben. Oberhalb der ersten Stromgrenze 33 flacht die erste Kennlinie 32 ab. Der Zusammenhang zwischen dem Strom 24 und dem aufbereiteten Ausgangssignal 19 wird zu höheren Strömen hin nichtlinear. Der höchste, zu messende Strom 31 entspricht dem ersten Wert 34 des Signals 19. Der Linearitätsbereich könnte bei der gegebenen Anorndung der Zangenbacken 10, 11 dadurch vergrößert werden, daß der erste Luftspalt 13 entsprechend vergrößert wird. Zu beachten ist hierbei aber, daß von einer bestimmten Luftspaltlänge an der magnetisch wirksame Spalt kleiner ist als der geometrische. Dies rührt daher, daß im ersten Luftspalt 13 die magnetische Flußdichte nicht nur im Innern des ersten Luftspalts 13 auftritt, sondern noch einen Parallelweg außerhalb des ersten Luftspalts 13 als Streufeld 26 wählt. Dieses Heraustreten der magnetischen Flußdichte aus dem ersten Luftspalt 13 tritt bereits vor der Sättigung des magnetisierbaren Materials auf, wie experimentell gezeigt werden konnte. Da die magnetische Flußdichte vom Sensor 14 gemessen wird, muß versucht werden, einen möglichst kleinen Streufeldeinfluß, das heißt, eine homogene magnetische Flußdichte im Luftspalt 13 zu erhalten. Eine Erhöhung der Länge des ersten Luftspalts 13 oder der Scherflächen sind deshalb Grenzen gesetzt.

Erfindungsgemäß ist zur weiteren Scherung des magnetischen Kreises deshalb der zweite Luftspalt 21 vorgesehen, dessen Länge mittels der Spaltfüllung 22 auf einen definierten Wert festgelegt ist. Es hat sich gezeigt, daß für den zweiten Luftspalt 21 eine Länge entsprechend nur etwa 1/10 der Länge des ersten Luftspalts 13 schon ausreichend ist, um mit der zusätzlich erreichten Scherung das Streufeldverhalten im ersten Luftspalt 13 zu vermindern. Mittels experimenteller Festlegung der Länge des zweiten Luftspalts 21 kann die in Figur 2 gezeigte zweite Kennlinie 35 erreicht werden, bei der gegenüber der ersten Kennlinie 32 die Stromgrenze 36, bis zu der der Zusammenhang zwischen dem Strom 24 und dem Signal 19 linear ist, zu höheren Stromwerten hin verschoben ist.

Das der zweiten Kennlinie 35 zugrundeliegende, an den Leitungen 16, 17 auftretende Signal des Sensors 14 ist geringer als das der ersten Kennlinie 32 zugrundeliegende Signal. Mittels der Verstärkeranordnung 18 können die beiden Kennlinien 32, 35 auf gleiches Niveau gebracht werden. Der höchste zu messende Strom 31 ergibt bei der zweiten Kennlinie 35 den zweiten Wert 37 des aufbereiteten Signals 19, der erheblich oberhalb dem ersten Wert 34 liegt und somit erheblich genauer den tatsächlich fließenden Strom 24 wiedergibt.

Die Spaltfüllung 22 ist vorzugsweise aus einer Folie hergestellt, die eine vorgegebene Dicke aufweist. Die Folie kann bei der Serienherstellung von Strommeßzangen am Ende des Fertigungsprozesses bei der Kalibrierung problemlos aufgebracht werden. Vorzugsweise kommt eine selbstklebende Folie zur Anwendung. Als Material für die Spaltfüllung 22 eignen sich sowohl unmagnetische als auch para- oder diamagnetische Werkstoffe. Die Verwendung von Metallen gegenüber Kunststoffen kann in dieser Anwendung Vorteile hinsichtlich der mechanischen Stabilität und hinsichtlich des thermischen Verhaltens bringen.

## Patentansprüche

1. Strommeßzange mit zwei zueinander beweglich angeordneten, zu einem magnetischen Kreis zusammenführbaren Zangenbacken (10, 11) aus magnetisierbarem Material, mit einer ersten Trennstelle (12), die einen ersten Luftspalt (13) bildet, in welchen ein magnetfeldempfindlicher Sensor (14) angeordnet ist, und mit einer zweiten Trennstelle (20), die einen zweiten Luftspalt (21) bildet, dadurch gekennzeichnet, daß die Länge des zweiten Luftspalts (21) in Abhängigkeit von der Scherung des magnetischen Kreises auf ein vorgegebenes Maß festgelegt ist.

2. Strommeßzange nach Anspruch 1, dadurch gekennzeichnet, daß die Länge des zweiten Luftspalts (21) kleiner oder gleich ungefähr 1/10 der Länge des ersten Luftspalts (13) ist.

3. Strommeßzange nach Anspruch 1 oder 2, dadurch gekennzeichnet daß die Länge des zweiten Luftspalts (21) mittels einer Folie (22) festgelegt ist.

4. Strommeßzange nach Anspruch 3, dadurch gekennzeichnet, daß eine selbstklebende Folie (22) vorgesehen ist.

5. Strommeßzange nach Anspruch 1, dadurch gekennzeichnet, daß als Sensor (14) ein Hall-Element vorgesehen ist.

6. Strommeßzange nach Anspruch 1, dadurch gekennzeichnet, daß die Zangenbacken (10, 11) einen Ringkern bilden.
